# EUROPEAN PATENT APPLICATION

(11) **EP 3 340 322 A1**
(43) Date of publication of application: **27.06.2018**
(21) Application number: 16205558.6
(22) Date of filing: 20.12.2016
(51) Int. Cl.: H01L 37/00, F25B 27/02, H01L 37/02, H01L 41/113, H02N 2/18

(54) **ENERGY HARVESTING UNIT, OUTDOOR AIR CONDITIONING UNIT COMPRISING AN ENERGY HARVESTING UNIT AND METHOD**

(71) Applicant: Vestel Elektronik Sanayi ve Ticaret A.S., 45030 Manisa (TR); Özyegin Üniversitesi, 34794 Çekmeköy/ Istanbul (TR)
(72) Inventor: GULBAHAR, Burhan, 45030 Manisa (TR); MEMISOGLU, Gorkem, 45030 Manisa (TR)
(74) Representative: Ascherl, Andreas

(57) **Abstract**

The present invention refers to an energy harvesting unit (1). Said energy harvesting unit (1) comprises a stack of material layers (2), wherein a passage for fluid flow is provided between the material layers (6), at least one temperature to electric energy transformation unit (8) and/or at least one vibration to electric energy transformation unit, wherein the temperature to electric energy transformation unit (8) and/or the vibration to electric energy transformation unit (10) is connected to at least one of said material layers (6), in particularly to a plurality of said material layers (6). According to the invention at least some of the material layers (6) are comprising, in particular consisting of, graphene.

## Description

This invention refers to an energy harvesting unit according to claim 1, an outdoor air conditioning unit according to claim 10, a cooling device for cooling electric elements according to claim 11 and a method according to claim 12.

### Background of the Invention

Outdoor air conditioning units emit warm air, thus energy losses due to noise, heat and vibration respectively air flow appear.

Prior art document US 2009/0000651 A1 discloses a method for using nanoporous materials to convert mechanical motion and/or heat into electrical energy. US 2009/0000651 A1 further discloses a mechanoelectric power generating device comprising: a nanoporous material disposed within a containment means, wherein the nanoporous material is capable of separating ions according to size; an electrolyte containing anions and cations disposed within the containment means, wherein the electrolyte is made up of anions and cations that differ in size so that the smaller ion is capable of permeating the nanoporous material, and wherein the larger ions are substantially excluded from the nanoporous material, and wherein the electrolyte is capable of being contained within the containment means; a loading means located and/or disposed within the containment means, wherein the loading means is capable of imparting a mechanical load upon the contents of the containment means, the load being sufficient to cause at least a portion of the electrolyte to at least partially infiltrate the nanoporous material; and at least one contact in electrical communication with the containment means, the electrolyte and/or the nanoporous material, wherein the contact is capable of harvesting any excess electrical charge.

The subject-matter of US 2009/0000651 A1 does not allow to convert more than one effect, like heat, acoustic noice or vibration, at the same time into electric energy.

### Object of the Invention

It is therefore the object of the present invention to provide a device, in particular an outdoor air conditioning unit, and a method that has a higher level of efficiency compared to the known devices and methods.

### Description of the Invention

The before mentioned object is solved by an energy harvesting unit according to claim 1. The energy harvesting unit according to the present invention preferably comprises at least a stack of material layers, wherein a passage for fluid flow is provided between the material layers, at least one temperature to electric energy transformation unit and/or at least one vibration to electric energy transformation unit, wherein the temperature to electric energy transformation unit and/or the vibration to electric energy transformation unit is connected to at least one of said material layers, in particularly to a plurality of said material layers. According to the invention at least some and preferably the majority or all of the material layers are comprising, in particular consisting of, graphene.

This solution is beneficial since such an energy harvesting unit has the ability of absorbing heat, acoustic noise or vibration at the same time, due to usage of parallel-plate (made of Graphene) structures for energy harvesting.

Graphene has significantly important properties allowing a great amount of harvesting and diversity at the same time. Graphene is the best material in the world in terms of the ratio of the area to height.

The energy harvesting device according to the present invention can be applied or can be part of indoor air conditioning units, outdoor air conditioning units, vehicles, in particular cars, preferably covering car motors, so that it operates in any temperature or challenging environmental conditions, and computer fans with better efficiency in terms of silent and/or energy, and cold computers.

Further preferred embodiments are subject-matter of dependent claims and/or of the following specification parts.

According to a preferred embodiment of the present invention the stack is formed by more than 100 and preferably more than 1000 and highly preferably more than 10000 graphene layers. The distance between each layer is preferably smaller than 100nm, in particular smaller than 10nm or smaller than 1 nm or smaller than 0,6nm, in particular 0,575nm.

These features are beneficial since the air force, heat energy and the acoustic vibrations are all absorbed gradually as they flow through the multi-layered blocking structure which preferably includes millions of single graphene layers, in particular up to 0,001 million or up to 0,01 million or up to 0,1 million or up to 1 million or up to 2 million or up to 5 million or up to 10 million layers preferably each layer at least comprises up to or more than 1% (weight) graphene up to or more than 10% graphene up to or more than 50% graphene up to or more than 90% graphene. For example, in an intercalated graphite structure, the distance between each single layer graphene is 0.575 nm in average. This means, in a height of 1 mm graphite structure, 2 million single layer graphene absorbers exist. This cannot be achieved currently available macro-scale or micro-scale piezo resistors, heat absorbers or isolation layers preventing the acoustic noise to radiate. Therefore, a 1 mm height of graphene absorber device allows us 2 million absorbing layers to be realized at the same time. In other words, we have 2 million/mm channels where air, heat or acoustic noise can be absorbed.

According to a further preferred embodiment of the present invention at least the majority of material layers, in particular all material layers, is functionally connected to the temperature to electric energy transformation unit and the vibration to electric energy transformation unit.

This embodiment is beneficial since the stack of graphene layers generates electricity as a vibrating piezoelectric material or thermoelectric material. Thus, a multi-layered blocking structure (stack) is provided to allow a coupling of wind force, heat and acoustic waves travelling in the air with piezoelectric and thermoelectric mechanism. Therefore, all these radiations or at least some of this radiation can be converted to electric energy.

The stack preferably forms an input section wherein radiation, in particular heated air and acoustic waves or vibrations can enter the stack or are guided into the stack. The stack further forms an outlet section to allow air to flow to the environment after flowing through a passage between material layers.

Some material layers are according to a further preferred embodiment of the present invention connected to the temperature to electric energy transformation unit and further material layers are connected to the vibration to electric energy transformation unit. This embodiment is beneficial since layers of graphene material are used to transform multiple effects into electric energy.

Each material layer is preferably individually connected to one temperature to electric energy transformation unit, wherein one temperature to electric energy transformation unit is provided for each material layer and/or each material layer is individually connected to one vibration to electric energy transformation unit, wherein one vibration to electric energy transformation unit is provided for each material layer. It is also conceivable that a plurality of layers is connected to one temperature to electric energy transformation unit and/or one vibration to electric energy transformation unit.

According to a further preferred embodiment of the present invention each temperature to electric energy transformation unit and/or each vibration to electric energy transformation unit is at least functionally and preferably by physical connection, connected to an energy storage means for storing electric energy. The energy storage means is preferably a battery unit or a capacitor unit. It is also conceivable that the electric energy is not stored inside an energy storage means of the device but feed into a grid or used to provide energy for an electric device, in particular an outdoor air conditioning unit.

The temperature to electric energy transformation unit is according to a preferred embodiment of the present invention a thermos-electric transducer means and/or the vibration to electric energy transformation unit is a piezoelectric or magnetoelectric pressure to electric transducer means. This embodiment is beneficial, since such units are well explored and are having high levels of efficiency.

The stack has a height of less than 5mm or of less than 3mm or of less than 1 mm. This embodiment is beneficial, since the overall size of the harvesting unit is very thin and therefore does not affect to overall dimensions significantly.

The before mentioned object is also solved by an air conditioning unit, in particular outdoor air conditioning unit, according to claim 10, in particular attachable to walls or roofs of houses. The air conditioning unit is a part of an air condition device, in particular an outdoor element of an air conditioning device. Said air conditioning unit preferably comprises at least a venting section, wherein the venting section preferably comprises a rotatable element which is preferably actuatable by a motor, wherein the venting section is arranged inside a housing and wherein at least one part of said housing forms an outlet to the outside of said housing, and an energy harvesting unit according to any of the proceeding claims, wherein the stack of material layers forms at least one section of said outlet in such a manner that vented air is able to flow through the passages between said material layers.

This solution is beneficial since the air conditioning unit, in particular outdoor air conditioning unit, is covered respectively modified with an energy harvesting unit, in particular specially designed and modelled graphene infrastructure, which can harvest energy from wind force, heat and acoustic noise and vibration at the same time. Therefore, all these three different negative outputs, i.e., wind, heat and noise, are converted to useful energy before they radiate out of the outdoor air conditioning unit to people or to the area in the outdoor living environment.

The before mention object is also solved by a cooling device for cooling electric elements, in particular CPUs or GPUs, according to claim 11. Said cooling device preferably comprises at least a venting section, wherein the venting section preferably comprises a rotatable element which is preferably actuatable by a motor, wherein the venting section is arranged inside a housing and wherein at least one part of said housing forms an outlet to the outside of said housing, and an energy harvesting unit according to any of the proceeding claims 1 to 9, wherein the stack of material layers forms at least one section of said outlet in such a manner that vented air is able to flow through the passages between said material layers. This solution is beneficial since heat and noise produced by CPU or GPU cooling devices can be

The before mentioned object is also solved by a method for generating energy. Said method preferably comprises the steps: Providing an energy harvesting unit according to any of claims 1 to 9, Causing a fluid to flow through the passages of the stack, and Transforming acoustic waves, pressure and heat into electric energy by means of the temperature to electric energy transformation unit and/or by means of the vibration to electric energy transformation unit.

Further benefits, goals and features of the present invention will be described by the following specification of the attached figures, in which components of the invention are exemplarily illustrated. Components of the devices and method according to the inventions, which match at least essentially with respect to their function can be marked with the same reference sign, wherein such components do not have to be marked or described in all figures.

The invention is just exemplarily described with respect to the attached figures in the following.

### Brief Description of the Drawings

- Fig. 1: shows schematically an outdoor air condition unit according to the present invention;
- Fig. 2: shows schematically an outdoor air condition unit according to the present invention, wherein the energy harvesting unit is schematically illustrated; and
- Fig. 3: shows schematically how heat and vibrations or acoustic waves are transformed into electric energy.

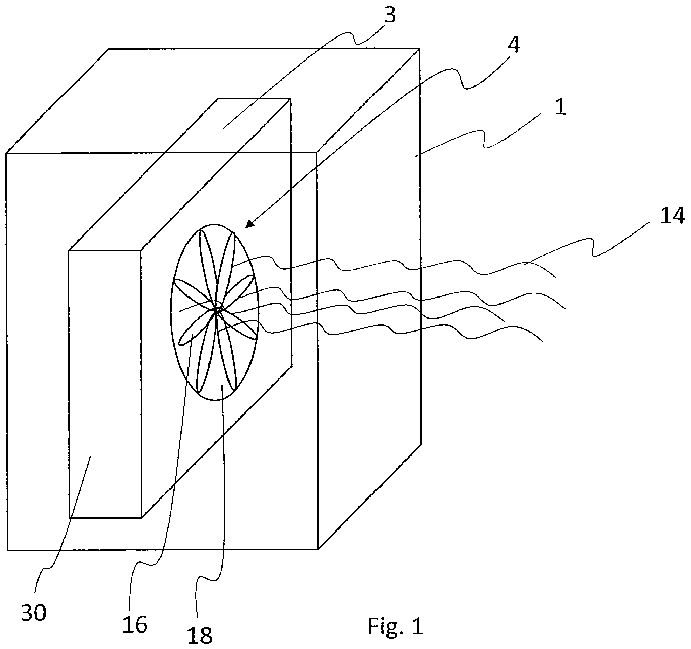

Fig. 1 shows an outdoor operation illustration of graphene layer 1 respectively energy harvesting unit 1 together with an outdoor AC unit 3.

The air conditioning unit 3, in particular outdoor air condition unit, is preferably covered with specially designed and modelled graphene infrastructure respectively with energy harvesting unit 1, which can harvest energy from wind force, heat and acoustic noise and vibration at the same time. Therefore, all these three different negative outputs, i.e., radiation 14 of wind, heat and noise, are converted to useful energy before they radiate out of the outdoor air conditioning unit 3 to people or to the area in the outdoor living environment. The air condition unit preferably comprises a venting section 4 having at least one rotatable element 16, in particular a rotor. Said rotating element 16 preferably rotates within or before an outlet through which air flows preferably from a warm side to a cold side. The energy harvesting unit 1 can be part of housing 30 but preferably covers outlet 18 in such a manner that air flowing through outlet 14 is directed trough material layers of energy harvesting unit 1.

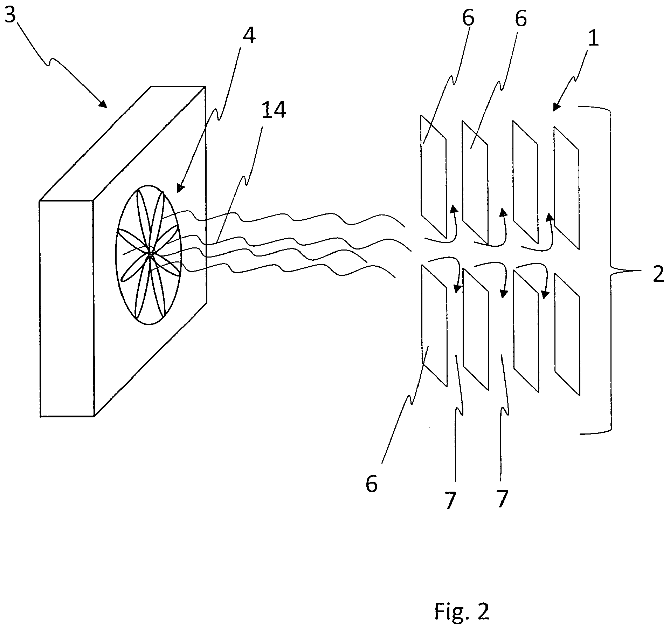

Fig. 2 shows an interlayer structure in particular a stack 2, of a graphene energy harvesting and absorbing device 1, as covering or as multi-layered structure.

Graphene can be used to generate electricity as a vibrating piezoelectric material or thermoelectric material. In case of a combination of a multi-layered blocking structure to face wind force, heat and acoustic waves travelling in the air with piezoelectric and thermoelectric mechanism then, all these radiations 14 (heat, wind force and acoustic waves) can be converted to electric energy. It can be seen from Fig. 2 that air flow is directed trough stack 2. Thus, the individual material layers 6 are oscillated and heated by said air flow, when the air flow passes through passages 7.

The air force, heat energy and the acoustic vibrations are all absorbed preferably gradually as they flow through the multi-layered blocking structure respectively stack 2 which preferably includes millions of single graphene layers 6.

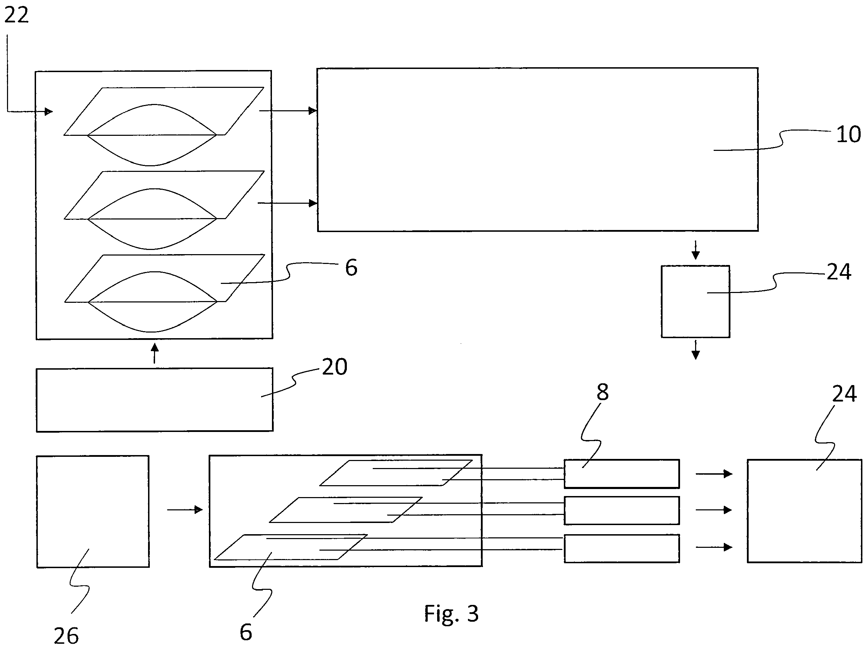

Fig. 3 shows to different mechanisms for converting effects like heat or vibration into electric energy.

Reference number 20 indicates an acoustic or air flow pressure, which is applied, in particular by means of air flow, to layers 6. Reference number 22 indicates that material layers 6 are oscillating due to the acoustic or air flow pressure. With at least one vibration to electric energy transformation unit 10 are the oscillations of at least one material layer 6 and preferably of a plurality or the majority of all material layers 6 transformed into electric energy. Said electric energy is then stored in an electric energy storage means 24.

Reference number 26 indicates heat, which is applied, in particular by means of fluid flow, in particular air flow, to material layers 6. With at least one temperature to electric energy transformation unit 8 energy is transformed into electric energy. Said electric energy is then stored in an electric energy storage means 24.

Both effects can be used at the same time for energy recovery, in particular for recovering electric energy from said air flow.

Thus, the present invention refers to Energy Harvesting, Heat Absorbing and Silent Outdoor Air Conditioning Unit with Multi-Layered Absorbing Graphene Infrastructure and Covering, wherein an energy harvesting unit, which e.g. can be used in outdoor air conditioning units, comprises at least a stack of material layers 2, wherein a passage for fluid flow is provided between the material layers 6, at least one temperature to electric energy transformation unit 8 and/or at least one vibration to electric energy transformation unit, wherein the temperature to electric energy transformation unit 8 and/or the vibration to electric energy transformation unit 10 is connected to at least one of said material layers 6, in particularly to a plurality of said material layers 6, wherein at least some of the material layers 6 are comprising or consisting of graphene.

### List of reference numbers

- 1: Energy harvesting unit
- 2: stack of material layers
- 3: air condition
- 4: venting section
- 6: material layers
- 7: passage
- 8: temperature to electric energy transformation unit
- 10: vibration to electric energy transformation unit
- 12: storage means
- 14: radiation
- 16: rotatable element
- 18: outlet
- 20: acoustic or air flow pressure
- 22: vibrations
- 24: electric energy storage
- 26: heat
- 30: housing

## Claims

1. Energy harvesting unit (1),
at least comprising
a stack of material layers (2),
wherein a passage for fluid flow is provided between the material layers (6),
at least one temperature to electric energy transformation unit (8) and/or at least one vibration to electric energy transformation unit,
wherein the temperature to electric energy transformation unit (8) and/or the vibration to electric energy transformation unit (10) is connected to at least one of said material layers (6), in particularly to a plurality of said material layers (6),
wherein at least some of the material layers (6) are comprising, in particular consisting of, graphene.

2. Energy harvesting unit according to claim 1,
**characterized in that**
the stack (2) is formed by more than 100 and preferably more than 1000 and highly preferably more than 10000 graphene layers (6).

3. Energy harvesting unit according to claim 2,
**characterized in that**
the distance between each layer (6) is smaller than 100nm, in particular smaller than 10nm or smaller than 1 nm or smaller than 0,6nm, in particular 0,575nm.

4. Energy harvesting unit according to any of the before mentioned claims,
**characterized in that**
at least the majority of material layers (6), in particular all material layers (6), is functionally connected to the temperature to electric energy transformation unit (8) and the vibration to electric energy transformation unit (10).

5. Energy harvesting unit according to any of the before mentioned claims 1 to 3,
**characterized in that**
some material layers (6) are connected to the temperature to electric energy transformation unit (8) and further material layers (6) are connected to the vibration to electric energy transformation unit (10).

6. Energy harvesting unit according to any of the before mentioned claims,
**characterized in that**
each material layer (6) is individually connected to one temperature to electric energy transformation unit (8), wherein one temperature to electric energy transformation unit (8) is provided for each material layer (6)
and/or
each material layer (6) is individually connected to one vibration to electric energy transformation unit (10), wherein one vibration to electric energy transformation unit (10) is provided for each material layer (6).

7. Energy harvesting unit according to any of the before mentioned claims,
**characterized in that**
each temperature to electric energy transformation unit (8) and/or each vibration to electric energy transformation unit (10) is at least functionally and preferably by physical connection connected to an energy storage means (12) for storing electric energy.

8. Energy harvesting unit according to any of the before mentioned claims,
**characterized in that**
temperature to electric energy transformation unit (8) is a thermos-electric transducer means and/or
vibration to electric energy transformation unit (10) is a piezoelectric or magnetoelectric pressure to electric transducer means.

9. Energy harvesting unit according to any of the before mentioned claims,
**characterized in that**
the stack (2) has a height of less than 5mm or of less than 3mm or of less than 1 mm.

10. Air conditioning unit (3), in particular attachable to walls or roofs of houses,
at least comprising
a venting section (4),
wherein the venting section (4) preferably comprises a rotatable element which is preferably actuatable by a motor,
wherein the venting section (4) is arranged inside a housing (30) and
wherein at least one part of said housing (30) forms an outlet to the outside of said housing (30),
and
an energy harvesting unit (1) according to any of the proceeding claims, wherein the stack of material layers (2) forms at least one section of said outlet in such a manner that vented air is able to flow through the passages (7) between said material layers (6).

11. Cooling device for cooling electric elements, in particular CPUs,
at least comprising
a venting section (4),
wherein the venting section (4) preferably comprises a rotatable element (16) which is preferably actuatable by a motor,
wherein the venting section (4) is arranged inside a housing (30) and
wherein at least one part of said housing (30) forms an outlet (18) to the outside of said housing (30),
and
an energy harvesting unit (1) according to any of the proceeding claims 1 to 9, wherein the stack of material layers (2) forms at least one section of said outlet in such a manner that vented air is able to flow through the passages (7) between said material layers (6).

12. Method for generating energy,
comprising the steps:
Providing an energy harvesting unit (1) according to any of claims 1 to 9 Causing a fluid to flow through the passages (7) of the stack (6),
Transforming acoustic waves, pressure and heat into electric energy by means of the temperature to electric energy transformation unit (8) and by means of the vibration to electric energy transformation unit (10).
